# EUROPEAN PATENT SPECIFICATION

(11) **EP 4 358 498 B1**
(45) Date of publication and mention of the grant of the patent: **30.07.2025**
(21) Application number: 23729648.8
(22) Date of filing: 02.06.2023
(51) Int. Cl.: H04M 1/02, H04M 1/23, H01Q 1/24, H05K 1/02, H05K 1/11, H05K 1/14, H01Q 1/22, H01Q 1/38, H01Q 13/10

(54) **ELECTRONIC DEVICE COMPRISING SIDE KEY FLEXIBLE PRINTED CIRCUIT BOARD**
ELEKTRONISCHE VORRICHTUNG MIT FLEXIBLER SEITENSCHLÜSSELLEITERPLATTE
DISPOSITIF ÉLECTRONIQUE COMPRENANT UNE CARTE DE CIRCUIT IMPRIMÉ SOUPLE À TOUCHE LATÉRALE

(30) Priority: 29.09.2022 KR 20220124508; 01.09.2022 KR 20220110915
(43) Date of publication of application: 24.04.2024
(73) Proprietor: Samsung Electronics Co., Ltd., Suwon-si, Gyeonggi-do 16677 (KR)
(72) Inventor: KIM, Kyoungtae, Gyeonggi-do 16677 (KR); KIM, Jungwoo, Gyeonggi-do 16677 (KR); CHO, Youngmin, Gyeonggi-do 16677 (KR); CHOI, Weonjai, Gyeonggi-do 16677 (KR)
(74) Representative: HGF
(86) International application number: PCT/KR2023/007593
(87) International publication number: WO 2024/048921

(56) References cited:
- CN-A- 106 657 473
- JP-A- 2019 193 127
- KR-A- 20130 028 571
- KR-A- 20220 071 666
- US-A1- 2020 303 810

## Description

### [TECHNICAL FIELD]

Embodiments of the disclosure relate to an electronic device including a side key flexible printed circuit board (FPCB). More particularly, the disclosure relates to a stacked wiring structure of the side key flexible circuit board and an internal structure of an electronic device in which the side key flexible circuit board is disposed.

### [BACKGROUND ART]

An electronic device such as a smartphone may provide various functions such as e.g., phone calling, multimedia playback or the like. A side key may be disposed on one side of the electronic device to provide some functions such as e.g., volume control of phone calling and/or multimedia playback, screen on/off or the like. When a button of the side key exposed to the outside is depressed, an actuating part connected to the button moves inward to the inside of the electronic device to press an outer contact part, so that a key input signal can be generated by an electrical contact between the outer contact part and an inner contact part. Further, the generated key input signal may be transferred to a processor mounted on a printed circuit board to perform a function related to a side key input.

In the meantime, the electronic device needs to efficiently secure a space for arranging at least one antenna, which is an essential component for communication, while preventing deterioration of radiation performance. For this end, a structure in which the antenna is arranged in a side key assembly may be considered.

US2020/303810 discloses a mobile device includes a first circuit board, a metal frame, an electronic component, a second circuit board, and an RF (Radio Frequency) module. The first circuit board includes a system ground plane. The metal frame at least includes a first portion. The first portion is electrically coupled to the system ground plane and a feeding point. An antenna structure is formed by the first portion and the feeding point. The second circuit board is electrically coupled to the electronic component. The electronic component and the second circuit board are adjacent to the first portion of the metal frame. The RF module is electrically coupled to the feeding point, so as to excite the antenna structure.

### [DISCLOSURE]

### [TECHNICAL SOLUTION]

In the course of operating at least one antenna equipped in a side key flexible circuit board (or assembly), malfunctions (e.g., ceased screen, screen slowdown, reboot, etc.) may occur in cameras disposed adjacent to the side key flexible circuit board due to current flowing therethrough. Such a malfunction of the camera may be alleviated or minimized by reducing (e.g., Tx backoff) the transmission power of the antenna placed on the side key circuit board or by minimizing placement of the antenna in an area adjacent to the camera, but it may cause occurrence of unnecessary backoff of the transmission power as well as considerable restrictions in mounting the antenna.

According to various embodiments of the disclosure, provided is an electronic device having a structure capable of minimizing malfunction of a camera, owing to an efficient design of a conductive wall and a side key flexible printed circuit board (FPCB) located in an area adjacent to the area in which the side key FPCB is disposed.

An electronic device 100 according to an embodiment of the disclosure includes a display 150, a housing 310 including a transparent front side plate 111 through which the display 150 can be viewed, a rear side plate 112 spaced apart from the front side plate and disposed to be parallel thereto, and a side surface member 113 connected to the front side plate and the rear side plate, at least one camera, at least one electronic component located inside the housing, a conductive wall 312 formed between the at least one camera and the at least one electronic component, a side key 320 located in at least one opening formed in a part of the side surface member, and a side key flexible printed circuit board (FPCB) for detecting a depression of the side key, and to generate and transmit an electrical signal in response to a detection of the depression of the side key. In an embodiment, a first portion of the side surface member adjacent to the side key is a first antenna. In an embodiment, the side key FPCB includes a first connector connected to the first antenna to transmit a first radio frequency (RF) signal to the first antenna. In an embodiment, the side key FPCB includes an extended part extending into an inside of the housing of the electronic device. In an embodiment, the extended part is disposed between the camera and the conductive wall. In an embodiment, the conductive wall includes at least one hole 404 formed in a partial region of the conductive wall corresponding to the extended part.

According to embodiments of the disclosure, it is advantageously possible to minimize camera radio frequency interference (RFI) that may occur when operating an antenna disposed on a side key circuit board when providing an electronic device according to the embodiments of the disclosure.

Further, according to embodiments of disclosure, it is advantageously possible to provide an effect of improving radio frequency (RF) performance of an electronic device by minimizing backoff of the transmission power in an upper antenna of the electronic device when providing an electronic device according to the embodiments of the disclosure.

Furthermore, according to embodiments of the disclosure, it is advantageously possible to provide an effect of minimizing spatial restrictions that may occur in arranging an antenna in an area around a camera mounted in an electronic device when providing an electronic device according to the embodiments of the disclosure.

The effects that can be obtained from the disclosure are not limited to those described above, and any other effects not mentioned herein will be clearly understood by those having ordinary knowledge in the technical field to which the disclosure belongs from the description below.

### [BRIEF DESCRIPTION OF THE DRAWINGS]

FIG. 1 illustrates a front side of an electronic device according to an embodiment;
FIG. 2 illustrates a rear side of an electronic device according to an embodiment;
FIG. 3 illustrates a housing and a side key of an electronic device according to an embodiment;
FIG. 4A illustrates a housing of an electronic device according to an embodiment;
FIG. 4B illustrates a housing and a side key flexible printed circuit board (FPCB) of an electronic device according to an embodiment;
FIG. 5A illustrates a side key FPCB according to an embodiment;
FIG. 5B illustrates a stacked structure of a side key FPCB according to an embodiment;
FIG. 6A illustrates a side key FPCB according to an embodiment;
FIG. 6B illustrates a side key FPCB according to an embodiment;
FIG. 6C illustrates a side key FPCB according to an embodiment;
FIG. 7 is a block diagram illustrating an example of configuration of an electronic device according to an embodiment; and
FIG. 8 illustrates a block configuration of a wireless communication module, a power management module, and an antenna module according to an embodiment.

In conjunction with the description of the drawings, the same or similar reference numerals may be used for the same or similar components.

### [BEST MODE]

Hereinafter, various embodiments of the disclosure are described with reference to the accompanying drawings. However, they are not intended to limit the disclosure to their specific embodiments, and should be appreciated that they may include various modifications, equivalents, and/or alternatives of embodiments of the disclosure. In the following description, like or similar reference numbers are used for substantially the same components, and any redundant descriptions may be omitted for clarity and conciseness.

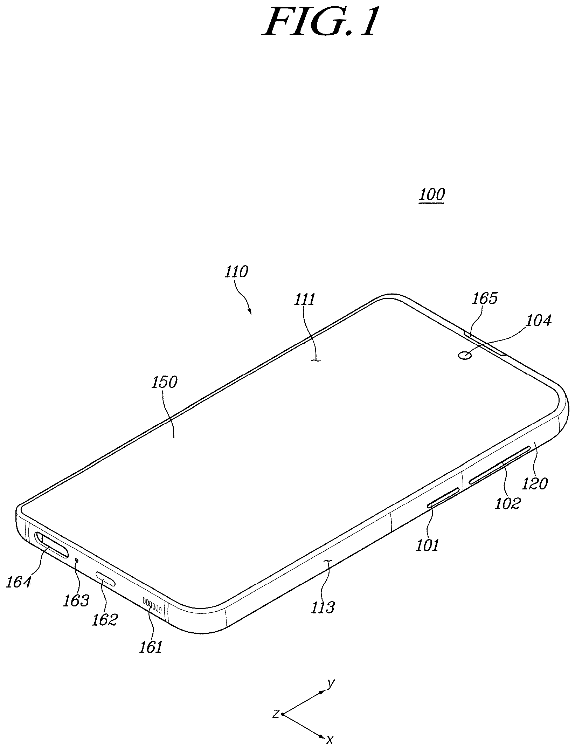

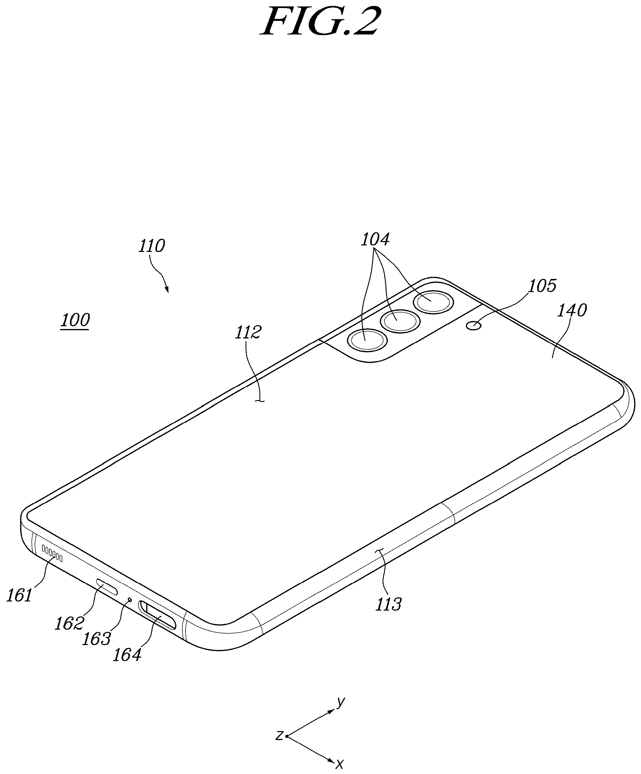

FIG. 1 illustrates a front side of an electronic device according to an embodiment. FIG. 2 illustrates a rear side of an electronic device according to an embodiment.

Referring to FIGS. 1 and 2, an electronic device 100 according to an embodiment may include a housing 110 including a front side plate 111 (e.g., a surface facing +z axis direction), a rear side plate 112 (e.g., a surface facing -z axis direction), and a side surface member 113 (e.g., a surface facing +x/-x axis directions and/or a surface facing +y/-y axis directions) surrounding a space between the front side plate 111 and the rear side plate 112. In the following description, the housing 110 may refer to a structure forming a portion of the front side plate 111, the rear side plate 112, and the side surface member 113.

In an embodiment, the front side plate 111 may be, for example, formed by a front plate (not shown) (e.g., a glass plate including various coating layers, or a polymer plate) at least a portion of which is substantially transparent. The rear side plate 112 may be formed by a substantially opaque rear plate 140. The rear plate 140 may be, for example, coated or colored glass, ceramic, polymer, metal (e.g., aluminum, stainless steel (STS), or magnesium), or a combination of at least two of these materials. The side surface member 113 may be coupled to a front plate (not shown) and a rear plate 140, and may be formed by a bracket 120 (e.g., a side bezel structure) including a metal and/or a polymer. The rear plate 140 and the bracket 120 may be integrally formed. The rear plate 140 may include transparent glass covering a camera.

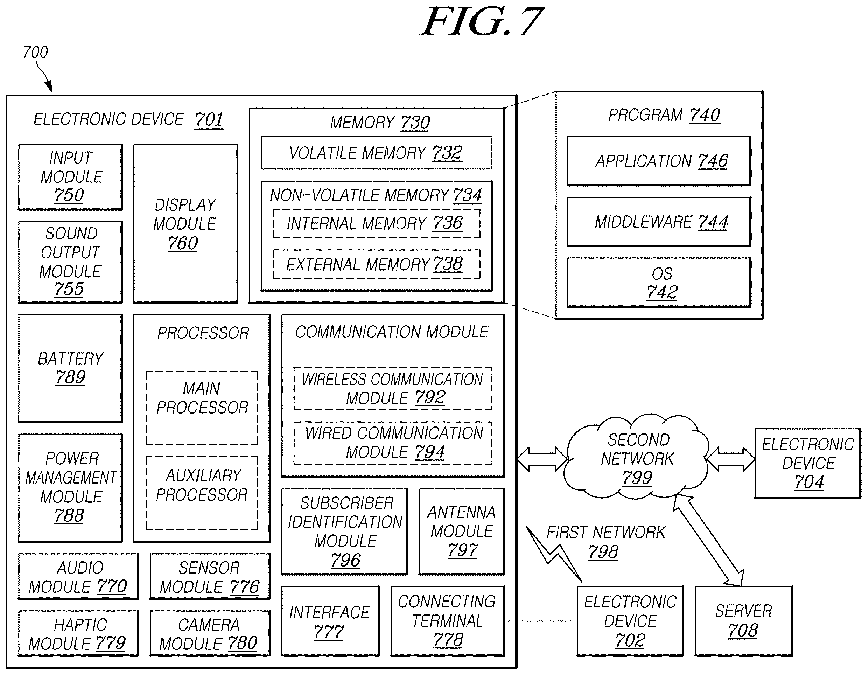

In an embodiment, the electronic device 100 may include at least one of a display 150 (e.g., a display module 760 of FIG. 7), at least one camera module (103, 104, 105) (e.g., a camera module 780 of FIG. 7), at least one key input device (101, 102) (e.g., an input module 750 of FIG. 7), a sensor module (not shown) (e.g., a sensor module 776 of FIG. 7), and a connector hole (not shown) (e.g., a connecting terminal 778 of FIG. 7). The electronic device 100 according to an embodiment may omit at least one of these components or additionally include another component.

In an embodiment, the display 150 may be visually exposed to the outside of the electronic device 100 through the front side plate 111 of the housing 110. For example, at least a portion of a surface of the housing 110 may include a screen display area formed as the display 150 is visually exposed. For example, the screen display area may be formed on at least a portion of the front side plate 111 of the housing 110. The display 150 may be coupled to or disposed adjacent to a touch sensing circuit, a pressure sensor capable of measuring the intensity (pressure) of a touch, and/or a digitizer for detecting a magnetic field type of stylus pen.

In an embodiment, the screen display area may include a sensing area (not shown) configured to acquire biometric information of a user. Here, the meaning of "the screen display area including a sensing area" may be understood to mean that at least a portion of the sensing area may be overlapped with the screen display area. For example, the sensing area, like other areas of the screen display area, may display visual information by the display 150, and may additionally refer to an area capable of acquiring biometric information (e.g., a fingerprint) of the user.

In an embodiment, the camera modules (103, 104, 105) may include a first camera module 103 (e.g., a punch hole camera) exposed to the front side plate 111 of the housing 110, a second camera module 104 exposed to the rear side plate 112 of the housing 110, and a flash 105. The first camera module 103 and the second camera module 104 may include one or more lenses, an image sensor, and/or an image signal processor. The flash 105 may include a light emitting diode or a xenon lamp. According to an embodiment, two or more lenses (infrared camera, wide-angle and telephoto lenses) and image sensors may be disposed on one surface of the electronic device 100.

In an embodiment, the first camera module 103 may be visually exposed through a portion of the screen display area of the display 150. For example, the first camera module 103 may be exposed to the front side plate 111 of the housing 110 and/or a partial area of the screen display area, through an opening (not shown) formed in a portion of the display 150.

In an embodiment, the second camera module 104 may include a plurality of camera modules (e.g., a dual camera, a triple camera, or a quad camera). However, the second camera module 104 is not necessarily limited to including a plurality of camera modules, and may include one camera module.

In an embodiment, the key input devices 101 and 102 may be disposed on the side surface member 113 of the housing 110. For example, the key input devices 101 and 102 may include at least one side key or a side button disposed on the bracket 120 of the housing 110. According to various embodiments of the disclosure, the electronic device 100 may not include some or all of the key input devices 101 and 102, and the key input devices 101 and 102 not installed therein may be implemented on the display 150 in another form such as a soft key.

In an embodiment, the electronic device 100 may perform a function of turning on/off the screen of the display 150 in response to inputs of the key input devices 101 and 102. Alternatively, it may perform a function of adjusting the volume of phone calling or multi-media playback in response to inputs of the key input devices 101 and 102. For example, The key input devices 101 and 102 may include a power key (e.g., 101) or a volume key (e.g., 102). According to various embodiments of the disclosure, the key input devices 101 and 102 may be configured to receive and/or obtain biometric information (e.g., a fingerprint) of a user. For example, the key input devices 101 and 102 may be configured with a fingerprint sensing button capable of sensing fingerprint. The key input devices 101 and 102 may include a fingerprint sensor module (not shown), and may be configured to sense a user's fingerprint by the fingerprint sensor module, when a user's body part (e.g., a finger) comes into contact with the key input devices 101 and 102.

In an embodiment, the sensor module (not shown) (e.g., a sensor module 776 of FIG. 7) may generate an electrical signal or a data value corresponding to an internal operation state or an external environment state of the electronic device 100. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an IR (infrared) sensor, a biometric sensor, a temperature sensor, a humidity sensor, an illuminance sensor, or the like.

In an embodiment, connector holes 62 and 164 may be configured to accommodate connectors. The connector holes 162 and 164 may be disposed on the side surface member 113 of the housing 110. In an embodiment, a first connector hole 164 may accommodate a connector (e.g., a USB connector) for transmitting and receiving power and/or data to/from an external electronic device, or a connector (e.g., an earphone jack) for transmitting and receiving audio signals to/from an external electronic device. In an embodiment, a second connector hole 162 may accommodate a storage device (e.g., a subscriber identification module (SIM) card).

In an embodiment, the electronic device 100 may include an audio module. In an embodiment, the audio module may include a microphone hole 163 and speaker holes 161 and 165. In the microphone hole 163 may be disposed a microphone for acquiring sound from the outside, and in some embodiments, a plurality of microphones may be disposed to detect a direction of the sound. The speaker holes may include an external speaker hole 161 and a receiver hole 165 for phone calling. In an embodiment, the speaker hole 161 and the microphone hole 163 may be implemented of a single hole, or a speaker (e.g., a piezo speaker) may be included without such a speaker hole 161.

In an embodiment, electromagnetic waves may be radiated through the side surface member 113 from a slot area (e.g., a first antenna area 316 and a second antenna area 318) of the housing corresponding to an antenna contact disposed on the side key.

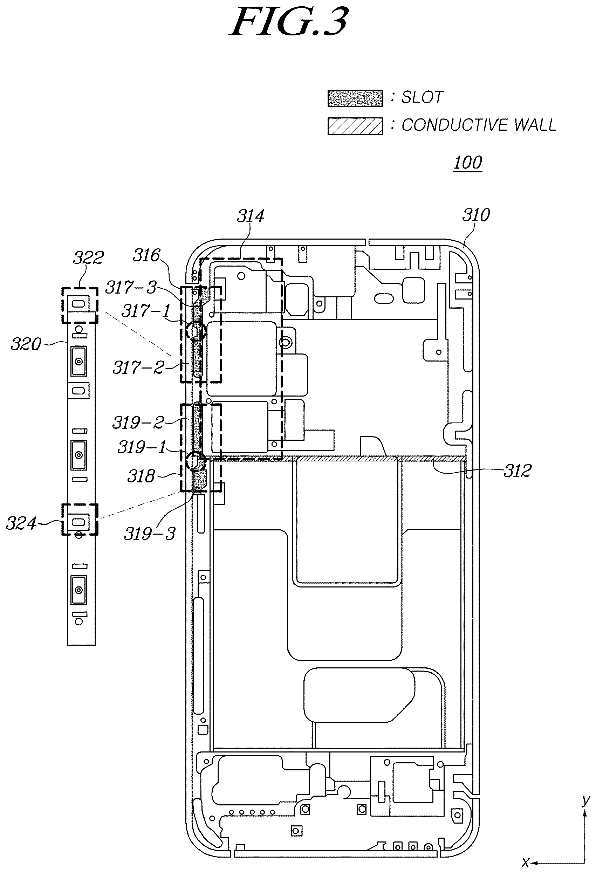

FIG. 3 illustrates a housing and a side key of an electronic device according to an embodiment.

Referring to FIG. 3, the electronic device 100 may include a housing 310 and a side key 320. The electronic device 100 of FIG. 3 may be a device corresponding to the electronic device 100 of FIGS. 1 and 2.

In an embodiment, the housing 310 may form part of a side surface member of the electronic device 100. A rear side plate (e.g., a rear plate 140) may be coupled to the housing 310.

In an embodiment, the housing 310 may include a conductive wall 312 formed across the side surface of the electronic device 100 in x-axis direction. The conductive wall 312 may be configured to spatially separate a region (hereinafter, referred to as an upper region) formed in a first direction (+y direction) of the housing 310 and a region (hereinafter, referred to as a lower region) formed in a second direction (-y direction). That is, if the conductive wall 312 is considered to be along a y = 0 line, then the upper region is a region of the housing and/or electronic device above the y-axis, and the lower region is a region of the housing and/or the electronic device below the y-axis.

In an embodiment, the conductive wall 312 may refer to a portion of the bracket 120 formed by an extending part of the side surface member 113. The bracket may be formed by extending the side surface member 113, and may support a display, a printed circuit board (PCB), a battery, or the like.

In an embodiment, the side surface member 113, the bracket 120, and the conductive wall 312 may be integrally formed. As the electronic device performs various functions, the conductive wall 312 may effectively block any noise that may occur in the upper and lower regions, respectively. That is, the conductive wall 312 may act to prevent or reduce noise which occurs in one region from affecting any components provided in the other region.

In an embodiment, a camera area 314 for disposing a camera (not shown) (e.g., a camera module 104) may be formed in the housing 310.

In an embodiment, the camera module 104 may be disposed in the camera area 314.

In an embodiment, the camera area 314 may be formed in +y direction with respect to the conductive wall 312. In an embodiment, the battery (not shown) may be disposed in -y direction with respect to the conductive wall 312. The camera and the battery may be spatially separated by the conductive wall 312. That is, the camera area may be provided in the upper region, and the battery may be provided in the lower region.

The side key 320 according to an embodiment may include the key input devices 101 and 102 of FIGS. 1 and 2, a circuit board including the same, and a bracket. Although not shown separately, the circuit board may include a printed circuit board (PCB) and/or a flexible printed circuit board (flexible PCB).

In an embodiment, at least one antenna contact may be disposed on the circuit board of the side key 320. For example, a first antenna contact may be disposed in a first region 322, and a second antenna contact may be disposed in a second region 324.

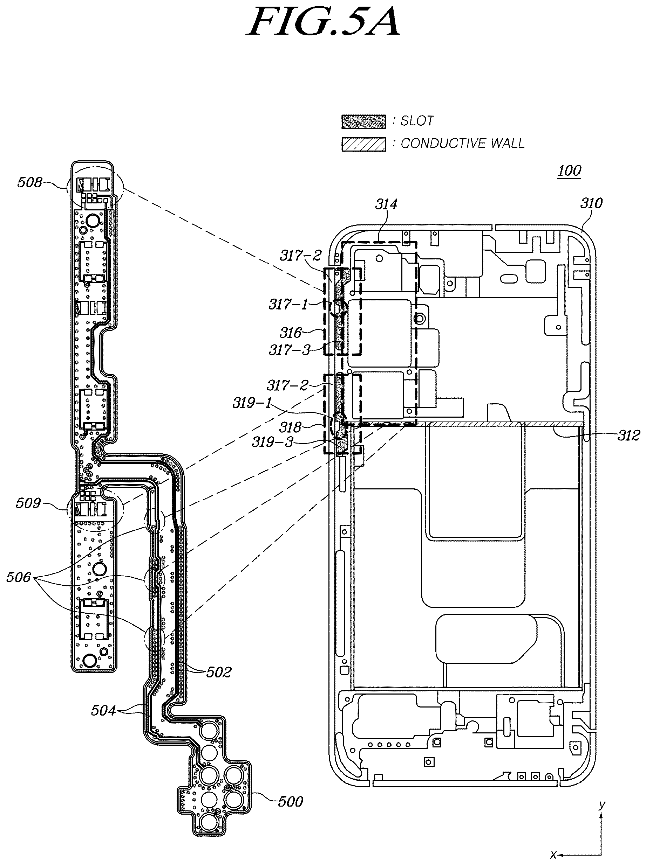

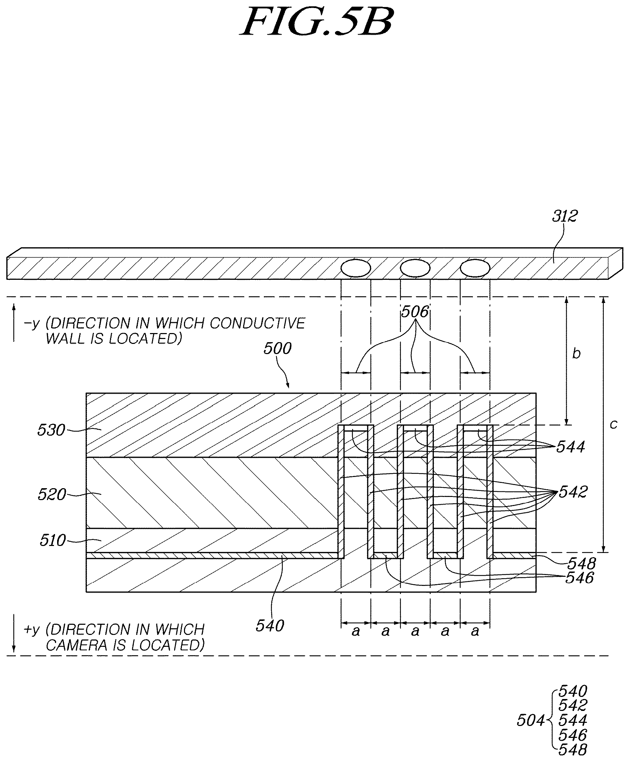

In an embodiment, although not shown in the drawings, the side key 320 may further include a side key FPCB connecting an antenna (e.g., a first antenna, a second antenna) and an internal component (e.g., a processor, a communication module, etc.) of the electronic device 100. The side key FPCB will be further described below with reference to FIGS. 5A and 5B.

In the housing 310, according to an embodiment, may be formed a first antenna area 316 to which the first antenna contact disposed in the first region 322 of the side key 320 is coupled, and a second antenna area 318 to which the second antenna contact disposed in the second region 324 of the side key 320 is coupled.

In an embodiment, the first antenna contact disposed in the first region 322 may be disposed in the first antenna area 316 of the housing 310, and the second antenna contact disposed in the second region 324 may be disposed in the second antenna area 318 of the housing 310.

In an embodiment, one or more slots may be formed in one or both of the first antenna area 316 and the second antenna area 318. For example, the first antenna area 316 may include a power feeder 317-1, a housing region 317-2 corresponding to a housing frame including the power feeder 317-1, and a slot region 317-3. Resonance may be generated through the slot region 317-3, and a signal may be radiated through the housing region 317-2. Further, for example, the second antenna area 318 may include a power feeder 319-1, a housing region 319-2 corresponding to the housing frame including the power feeder 319-1, and a slot region 319-3. Resonance may be generated through the slot region 319-3, and a signal may be radiated through the housing region 319-2.

In an embodiment, the electronic device 100 may perform power feeding by contacting the first antenna contact disposed in the first region 322 with the power feeder 317-1. For example, the electronic device 100 may perform power feeding by contacting the second antenna contact disposed in the second region 324 with the power feeder 319-1.

Although not shown in the drawings, the side key FPCB connected to the side key 320 may connect an internal component (e.g., a communication module, a processor, etc.) of the electronic device 100 and the antenna (e.g., a first antenna, a second antenna) disposed on the side key 320, across a space formed in the camera area 314 and the conductive wall 312.

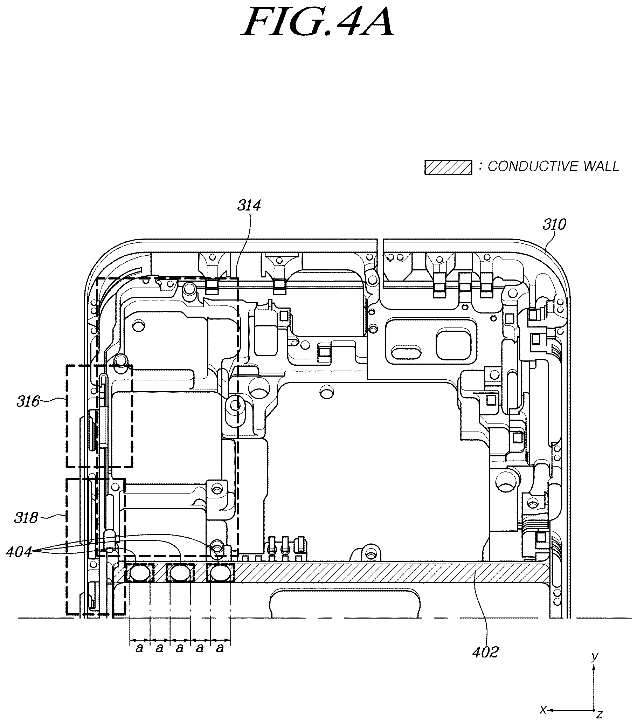

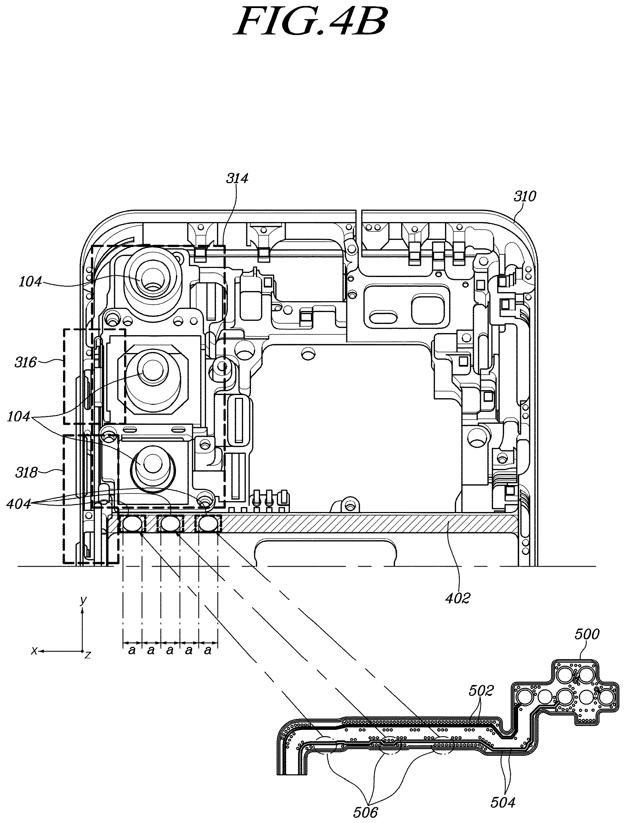

FIG. 4A illustrates a housing of an electronic device according to an embodiment. FIG. 4B illustrates a housing and a side key flexible printed circuit board (FPCB) of an electronic device according to an embodiment. FIG. 4A is an enlarged view of an upper region of the housing 310 shown in FIG. 3 and a region including the conductive wall 312. A side key FPCB 500 of FIG. 4B may refer to the configuration of connecting the antenna (e.g., a first antenna, a second antenna) of the side key 320 and the internal component (e.g., a processor, a communication module) of the electronic device, although not illustrated in FIG. 3.

Referring to FIG. 4A, the housing 310 may include a conductive wall 402. The conductive wall 402 may have a configuration corresponding to the conductive wall 312 of FIG. 3.

According to an embodiment, the conductive wall 402 may include at least one hole 404. In FIGS. 4A and hereinafter, the conductive wall 402 is shown to include three holes, but this is only an example and may include less than or more than three holes.

In an embodiment, the hole 404 may be formed in an area adjacent to the camera area 314. For example, the hole 404 may be formed in an area overlapping the camera area 314 with respect to the y-axis. Since the hole is for reducing radio frequency interference (RFI) of the camera when operating the antenna included in the side key, at least one hole may be formed in the camera area 314 in which the camera is disposed. That is, the function of the hole 404 is to help reduce the radio frequency interference experienced by the camera when the antenna included in the side key is being operated. As such, the at least one hole may be formed in the area or region in which the camera is provided.

In an embodiment, the holes 404 may be formed in the y-axis direction. In other words, the cross section of the hole may be a plane parallel to an x-z plane having the y-axis as a normal line. In other words, the holes 404 may be provided along a y = 0 direction. Noise generated from the FPCB disposed between the camera area and the conductive wall 402 through the hole formed in the conductive wall 402 is spread in the second direction (the -y direction) to form a radiation pattern from the upper region to the lower region, thereby causing the noise to be dispersed. Accordingly, the effect of noise on the camera may be reduced due to the current flowing through the FPCB.

In an embodiment, the width of the holes 404 may be formed to be the same as each other. For example, as shown in FIG. 4A, all three holes may have the same length (a). In other words, all of the holes may have the same diameter. As shown in Figure 4A, all three holes have a diameter of size or length *a*.

In an embodiment, the interval between the holes 404 may be formed substantially the same as the width of the hole. For example, as shown in FIG. 4A, the distance between the holes may be formed substantially the same as the length (a), which is a width of the hole. In other words, the distance between holes may be equal to (or substantially equal to) the diameter of the holes. As shown in Figure 4A, both the diameter of the holes and the separation between successive holes has a value or length of *a.*

In an embodiment, the hole 404 is shown to have an ellipse shape in the drawing, but it is only an example and the hole 404 may have various shapes such as e.g., a circular shape, a polygon or the like (e.g., a triangle, a square, a pentagon, etc.). Where the holes are ellipse-shaped, the terms 'diameter', 'length' or 'size' of the hole refer to a measure of the distance from one side of the hole to the other, passing through the center of the hole.

In order to form a radiation pattern in the lower region through the hole 404 according to an embodiment, the side key FPCB 500 may also have a corresponding structure. FIG. 4B shows a partial region of the side key FPCB, and it may illustrate a partial region of the side key FPCB 500 illustrated in FIG. 5A as below.

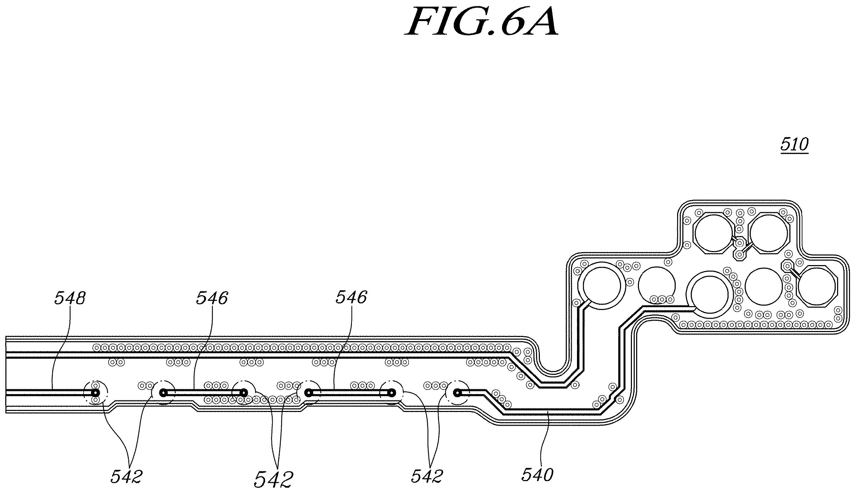

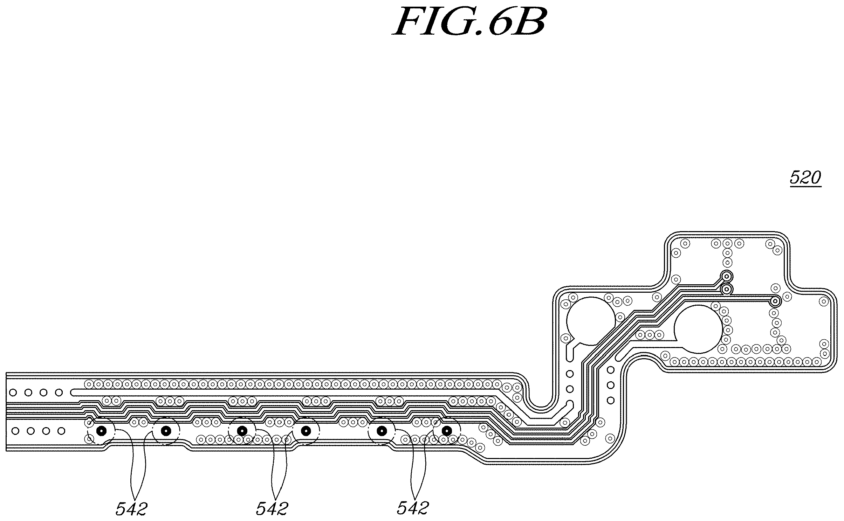

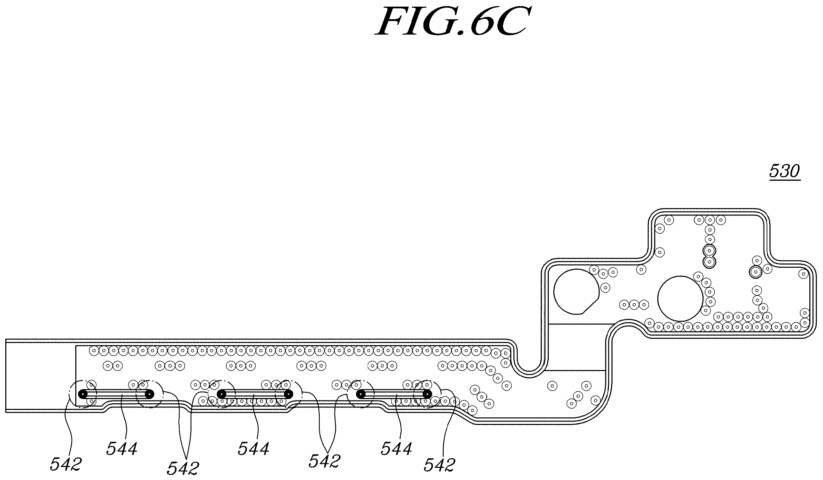

In an embodiment, the side key FPCB 500 may include three layers. For example, the side key FPCB 500 may have a structure of three layers in which a base layer, a first conductive layer formed in a +y-axis direction with respect to the base layer, and a second conductive layer formed in a -y-axis direction with respect to the base layer are stacked in three layers. For the convenience of the description, in the following description, the base layer may be referred to as a "second layer", the first conductive layer may be referred to as a "first layer", and the second conductive layer may be referred to as a "third layer". The structure of the side key FPCB will be described in more detail in FIGS. 5A, 5B, 6A, 6B, and 6C.

In an embodiment, the side key FPCB 500 may include a transmission line 502 connected to the first antenna and a transmission line 504 connected to the second antenna. The transmission line 502 may connect the first antenna to an internal component (e.g., a processor, a communication module) of the electronic device 100, and the transmission line 504 may connect the second antenna to an internal component (e.g., a processor, a communication module) of the electronic device 100.

In an embodiment, the side key FPCB 500 may be disposed between the camera area 314 and the conductive wall 402. The transmission line disposed or formed on the side key FPCB 500 may be wired to the third layer, and a ground layer may be formed on the first or second layer. For example, the side key FPCB 500 may form wiring in the form of a microstrip line. The transmission line may be arranged or formed to be wired to a partial area of the third layer overlapping the area in which the hole is formed and to be exposed to the outside. For example, the transmission line may be a conductive pattern formed on the upper surface of the second layer. In the case of an area other than a hole area 506, the second transmission line 504 may be disposed on the first layer, and the first and third layers may be connected through a via or the like. When the side key FPCB 500 is disposed, the hole area 506 may refer to an area on the side key FPCB 500 overlapping the area in which at least one hole 404 of the conductive wall 402 is formed.

FIG. 5A illustrates a side key FPCB according to an embodiment. In the description of FIG. 5A, content overlapping with the content described in FIGS. 1 to 4B may be omitted, and the same configuration may be described with the same reference numeral(s). FIG. 5A illustrates the side key FPCB 500 of FIG. 4B. Referring to FIG. 5A, the first region 508 may refer to a region corresponding to the first region 322 of FIG. 3, in which the first antenna contact is disposed, and the second region 509 may refer to a region corresponding to the second region 324 of FIG. 3, in which the second antenna contact is disposed.

In an embodiment, the side key FPCB 500 may be disposed to pass between the area in which the camera is disposed and the area in which the conductive wall is formed. In the case of the hole area 506 corresponding to the area in which the hole 404 of the conductive wall 402 is formed, a transmission line may be wired to the third layer, and a ground layer may be formed on the first or second layer. For example, a wiring in the form of a microstrip line may be formed. For example, the transmission line may be disposed on an upper surface of the second layer. In the case of an area other than the hole area 506, the second transmission line 504 may be disposed on the first layer, and the first and third layers may be connected through a via or the like.

FIG. 5B illustrates a stacked structure of a side key FPCB according to an embodiment. FIG. 5B illustrates a stacked structure of an area including the hole area 506 of the side key FPCB 500 shown in FIG. 5A.

Referring to FIG. 5B, the side key FPCB 500 may include three layers. In an embodiment, the side key FPCB 00 may include a base layer 520, a first conductive layer 510, and a second conductive layer 530. The first conductive layer 510 and the second conductive layer 530 may be arranged or formed in the first direction and the second direction of the base layer 520. The first direction may refer to +y direction (the direction in which the conductive wall 402 faces the camera area 314) with respect to the base layer 520, and the second direction may refer to -y direction (a direction opposite to the direction in which the conductive wall 402 faces the camera area 314) with respect to the base layer 520. The base layer 520 may be formed of an insulating material, and may serve to separate the first conductive layer 510 from the second conductive layer 530. In the following description, the first conductive layer 510 may be referred to as a "first layer", the base layer 520 as a "second layer", and the second conductive layer 530 as a "third layer".

In an embodiment, the side key FPCB 500 may include a transmission line 504 formed in the first conductive layer 510, the base layer 520, and the second conductive layer 530. An electrical signal may flow between an internal component (e.g., a processor, a communication module, etc.) of the electronic device 100 and a component (e.g., a first antenna, a second antenna, etc.) disposed on the side key 320, through a transmission line. The transmission line 504 may include a conductive material.

In an embodiment, the transmission line 504 may refer to a line formed by connecting a first transmission line 540, 546 and 548, a plurality of vias 542, and a second transmission line 544 in succession. The first transmission lines 540, 546, and 548 may refer to a portion disposed or formed on the first conductive layer 510 in the transmission line 504, and the second transmission line 544 may refer to a portion disposed or formed on the second conductive layer in the transmission line 504. The second transmission line 544 may be formed only in the hole area 506 and may be connected through the plurality of vias 542.

In an embodiment, the first conductive layer 510 may include first transmission lines 540, 546, and 548 through which electrical signals flow. The first transmission lines 540, 546, and 548 may be disposed or formed adjacent to the base layer 520. For example, although not shown in the drawings, the first transmission lines 540, 546, and 548 and the base layer 520 may have a structure attached to each other. The first transmission lines 540, 5460, and 548 may be conductive patterns formed on a lower surface of the base layer 520. A portion of the first conductive layer 510 surrounding the first transmission lines 540, 546, and 548 may include an insulating material. The 'transmission line' described throughout the following description may be referred to as 'wiring', 'wiring pattern', 'signal line', 'transmission line', or any other terms equivalent thereto.

In an embodiment, the second conductive layer 530 may include a second transmission line 544 through which an electrical signal flows. Although not shown in the drawings, the transmission line 544 may be arranged or formed to be wired to a partial area of the second conductive layer 530 overlapping the hole area 506 and exposed to the outside. For example, the second transmission line 544 may be a conductive pattern formed on an upper surface of the second conductive layer 530. In the case of a transmission line for an antenna being arranged on the first conductive layer 510, the performance of the antenna may be satisfied, but the transmission line is placed adjacent to the camera, so that radio frequency interference (RFI) may occur in the camera. Thus, some wirings in an area adjacent to the camera may be pulled up to the third floor to disperse noise. Such a configuration makes it possible to disperse the current distribution, by forming a radiation pattern in the rear side direction of the electronic device.

In an embodiment, although not shown in the drawings, the transmission line 504 may include a ground layer in the first conductive layer 510 or the base layer 520.

In an embodiment, the second transmission lines 544 may have the same length (a). In an embodiment, the first transmission lines 546 may have the same length. In an embodiment, the first transmission lines 546 and the second transmission lines 544 may have the same length.

In an embodiment, the side key FPCB 500 may include a plurality of vias 542. The plurality of vias 542 may be disposed or formed at a boundary area in between the hole area 506 and a portion other than the hole area 506. The plurality of vias 542 may include a conductive material.

In an embodiment, the first conductive layer 510 and the second conductive layer 530 may be connected through a plurality of vias 542. The plurality of vias 542 may connect the first transmission lines 540, 546, and 548 to the second transmission line 544. The plurality of vias 542 may be disposed or formed to pass through the base layer 520.

In an embodiment, the first transmission line 540 may be connected to an internal configuration (e.g., a processor, a communication module, etc.) of the electronic device 100. In an embodiment, the first transmission line 546 may be disposed or formed in between the hole areas 506.

In an embodiment, the first transmission line 548 may be connected to the side key 320.

In an embodiment, the distance (b) between the second transmission line 544 and the hole may be less than the distance (c) between the first transmission lines 540, 546, and 548 and the conductive wall.

In an embodiment, at least one camera may be disposed in -y direction with respect to the second conductive layer 530. In an embodiment, the battery and other electronic components may be disposed in +y direction with respect to the first conductive layer 510.

FIG. 6A illustrates a side key FPCB according to an embodiment. FIG. 6B illustrates a side key FPCB according to another embodiment. FIG. 6C illustrates a side key FPCB according to yet another embodiment. FIG. 6A illustrates the first conductive layer 510 of FIG. 5B. FIG. 6B illustrates the base layer 520 of FIG. 5B. FIG. 6C illustrates the second conductive layer 530 of FIG. 5B.

Referring to FIG. 6A, the first transmission lines 540, 546, and 548 may be disposed or formed on the first conductive layer 510. Referring to FIG. 6B, a plurality of vias 542 may be disposed or formed on the base layer 520. Referring to FIG. 6C, a second transmission line 544 may be formed in the second conductive layer 530.

FIG. 7 is a block diagram illustrating an electronic device 701 in a network environment 700 according to various embodiments. Referring to FIG. 1, the electronic device 701 in the network environment 700 may communicate with an electronic device 702 via a first network 798 (e.g., a short-range wireless communication network), or an electronic device 704 or a server 708 via a second network 799 (e.g., a long-range wireless communication network). According to an embodiment, the electronic device 701 may communicate with the electronic device 704 via the server 708. According to an embodiment, the electronic device 701 may include a processor 720, memory 730, an input module 750, a sound output module 755, a display module 760, an audio module 770, a sensor module 776, an interface 777, a connecting terminal 778, a haptic module 779, a camera module 780, a power management module 788, a battery 789, a communication module 790, a subscriber identification module (SIM) 796, or an antenna module 797. In some embodiments, at least one (e.g., the connecting terminal 778) of the components may be omitted from the electronic device 701, or one or more other components may be added in the electronic device 701. According to an embodiment, some (e.g., the sensor module 776, the camera module 780, or the antenna module 797) of the components may be integrated into a single component (e.g., the display module 760).

The processor 720 may execute, for example, software (e.g., a program 740) to control at least one other component (e.g., a hardware or software component) of the electronic device 701 coupled with the processor 720, and may perform various data processing or computation. According to an embodiment, as at least part of the data processing or computation, the processor 720 may store a command or data received from another component (e.g., the sensor module 776 or the communication module 790) in volatile memory 732, process the command or the data stored in the volatile memory 732, and store resulting data in non-volatile memory 734. According to an embodiment, the processor 720 may include a main processor 721 (e.g., a central processing unit (CPU) or an application processor (AP)), or an auxiliary processor 723 (e.g., a graphics processing unit (GPU), a neural processing unit (NPU), an image signal processor (ISP), a sensor hub processor, or a communication processor (CP)) that is operable independently from, or in conjunction with, the main processor 721. For example, when the electronic device 701 includes the main processor 721 and the auxiliary processor 723, the auxiliary processor 723 may be configured to use lower power than the main processor 721 or to be specified for a designated function. The auxiliary processor 723 may be implemented as separate from, or as part of the main processor 721.

The auxiliary processor 723 may control at least some of functions or states related to at least one component (e.g., the display module 760, the sensor module 776, or the communication module 790) among the components of the electronic device 701, instead of the main processor 721 while the main processor 721 is in an inactive (e.g., sleep) state, or together with the main processor 721 while the main processor 721 is in an active state (e.g., executing an application). According to an embodiment, the auxiliary processor 723 (e.g., an image signal processor or a communication processor) may be implemented as part of another component (e.g., the camera module 780 or the communication module 790) functionally related to the auxiliary processor 723. According to an embodiment, the auxiliary processor 723 (e.g., the neural processing unit) may include a hardware structure specified for artificial intelligence model processing. The artificial intelligence model may be generated via machine learning. Such learning may be performed, e.g., by the electronic device 701 where the artificial intelligence is performed or via a separate server (e.g., the server 708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 730 may store various data used by at least one component (e.g., the processor 720 or the sensor module 776) of the electronic device 701. The various data may include, for example, software (e.g., the program 740) and input data or output data for a command related thereto. The memory 730 may include the volatile memory 732 or the non-volatile memory 734.

The program 740 may be stored in the memory 730 as software, and may include, for example, an operating system (OS) 742, middleware 744, or an application 746.

The input module 750 may receive a command or data to be used by other component (e.g., the processor 720) of the electronic device 701, from the outside (e.g., a user) of the electronic device 701. The input module 750 may include, for example, a microphone, a mouse, a keyboard, keys (e.g., buttons), or a digital pen (e.g., a stylus pen).

The sound output module 755 may output sound signals to the outside of the electronic device 701. The sound output module 755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 760 may visually provide information to the outside (e.g., a user) of the electronic device 701. The display 760 may include, for example, a display, a hologram device, or a projector and control circuitry to control a corresponding one of the display, hologram device, and projector. According to an embodiment, the display 760 may include a touch sensor configured to detect a touch, or a pressure sensor configured to measure the intensity of a force generated by the touch.

The audio module 770 may convert a sound into an electrical signal and vice versa. According to an embodiment, the audio module 770 may obtain the sound via the input module 750, or output the sound via the sound output module 755 or a headphone of an external electronic device (e.g., an electronic device 702) directly (e.g., wiredly) or wirelessly coupled with the electronic device 701.

The sensor module 776 may detect an operational state (e.g., power or temperature) of the electronic device 701 or an environmental state (e.g., a state of a user) external to the electronic device 701, and then generate an electrical signal or data value corresponding to the detected state. According to an embodiment, the sensor module 776 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 777 may support one or more specified protocols to be used for the electronic device 701 to be coupled with the external electronic device (e.g., the electronic device 702) directly (e.g., wiredly) or wirelessly. According to an embodiment, the interface 777 may include, for example, a high definition multimedia interface (HDMI), a universal serial bus (USB) interface, a secure digital (SD) card interface, or an audio interface.

A connecting terminal 778 may include a connector via which the electronic device 701 may be physically connected with the external electronic device (e.g., the electronic device 702). According to an embodiment, the connecting terminal 778 may include, for example, a HDMI connector, a USB connector, a SD card connector, or an audio connector (e.g., a headphone connector).

The haptic module 779 may convert an electrical signal into a mechanical stimulus (e.g., a vibration or motion) or electrical stimulus which may be recognized by a user via his tactile sensation or kinesthetic sensation. According to an embodiment, the haptic module 779 may include, for example, a motor, a piezoelectric element, or an electric stimulator.

The camera module 780 may capture a still image or moving images. According to an embodiment, the camera module 780 may include one or more lenses, image sensors, image signal processors, or flashes.

The power management module 788 may manage power supplied to the electronic device 701. According to an embodiment, the power management module 788 may be implemented as at least part of, for example, a power management integrated circuit (PMIC).

The battery 789 may supply power to at least one component of the electronic device 701. According to an embodiment, the battery 789 may include, for example, a primary cell which is not rechargeable, a secondary cell which is rechargeable, or a fuel cell.

The communication module 790 may support establishing a direct (e.g., wired) communication channel or a wireless communication channel between the electronic device 701 and the external electronic device (e.g., the electronic device 702, the electronic device 704, or the server 708) and performing communication via the established communication channel. The communication module 790 may include one or more communication processors that are operable independently from the processor 720 (e.g., the application processor (AP)) and supports a direct (e.g., wired) communication or a wireless communication. According to an embodiment, the communication module 790 may include a wireless communication module 792 (e.g., a cellular communication module, a short-range wireless communication module, or a global navigation satellite system (GNSS) communication module) or a wired communication module 794 (e.g., a local area network (LAN) communication module or a power line communication (PLC) module). A corresponding one of these communication modules may communicate with the external electronic device 704 via a first network 798 (e.g., a short-range communication network, such as Bluetooth^{™}, wireless-fidelity (Wi-Fi) direct, or infrared data association (IrDA)) or a second network 799 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 792 may identify or authenticate the electronic device 701 in a communication network, such as the first network 798 or the second network 799, using subscriber information (e.g., international mobile subscriber identity (IMSI)) stored in the subscriber identification module 796.

The wireless communication module 792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 792 may support a high-frequency band (e.g., the mmWave band) to achieve, e.g., a high data transmission rate. The wireless communication module 792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 792 may support various requirements specified in the electronic device 701, an external electronic device (e.g., the electronic device 704), or a network system (e.g., the second network 799). According to an embodiment, the wireless communication module 792 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 797 may transmit or receive a signal or power to or from the outside (e.g., the external electronic device). According to an embodiment, the antenna module 797 may include one antenna including a radiator formed of a conductor or conductive pattern formed on a substrate (e.g., a printed circuit board (PCB)). According to an embodiment, the antenna module 797 may include a plurality of antennas (e.g., an antenna array). In this case, at least one antenna appropriate for a communication scheme used in a communication network, such as the first network 798 or the second network 799, may be selected from the plurality of antennas by, e.g., the communication module 790. The signal or the power may then be transmitted or received between the communication module 790 and the external electronic device via the selected at least one antenna. According to an embodiment, other parts (e.g., radio frequency integrated circuit (RFIC)) than the radiator may be further formed as part of the antenna module 797.

According to various embodiments, the antenna module 797 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 701 and the external electronic device 704 via the server 708 coupled with the second network 799. The external electronic devices 702 or 704 each may be a device of the same or a different type from the electronic device 701. According to an embodiment, all or some of operations to be executed at the electronic device 701 may be executed at one or more of the external electronic devices 702, 704, or 708. For example, if the electronic device 701 should perform a function or a service automatically, or in response to a request from a user or another device, the electronic device 701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 701. The electronic device 701 may provide the outcome, with or without further processing of the outcome, as at least part of a reply to the request. To that end, a cloud computing, distributed computing, mobile edge computing (MEC), or client-server computing technology may be used, for example. The electronic device 701 may provide ultra low-latency services using, e.g., distributed computing or mobile edge computing. In another embodiment, the external electronic device 704 may include an Internet-of-things (IoT) device. The server 708 may be an intelligent server using machine learning and/or a neural network. According to an embodiment, the external electronic device 704 or the server 708 may be included in the second network 799. The electronic device 701 may be applied to intelligent services (e.g., smart home, smart city, smart car, or healthcare) based on 5G communication technology or IoT-related technology.

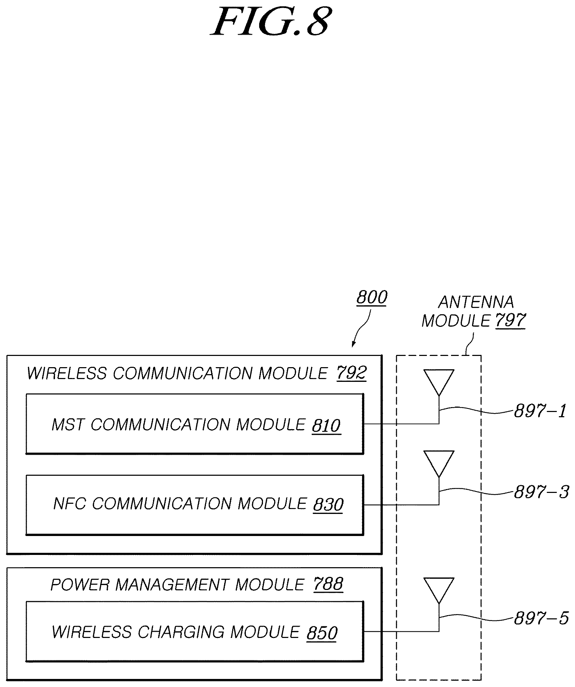

FIG. 8 is a block diagram 800 illustrating a wireless communication module 792, a power management module 788, and an antenna module 797 of an electronic device 701 according to various embodiments. Referring to FIG. 8, the wireless communication module 792 may include an MST communication module 810 or an NFC communication module 830, and the power management module 788 may include a wireless charging module 850. In such a circumstance, the antenna module 897 may include a plurality of antennas including an MST antenna 897-1 connected to the MST communication module 810, an NFC antenna 897-3 connected to the NFC communication module 830, and a wireless charging antenna 897-5 connected to the wireless charging module 850. For convenience of description, components overlapping those of FIG. 7 will be omitted or briefly described.

The MST communication module 810 may receive, from the processor 720, a signal including control information or payment-related information such as card information, generate a magnetic signal corresponding to the received signal via the MST antenna 897-1, and then transmit the generated magnetic signal to the external electronic device 702 (e.g., a POS device). According to an embodiment, in order to generate the magnetic signal, the MST communication module 810 may include a switching module (not shown) including one or more switches connected to the MST antenna 897-1, and may control the switching module to change a direction of a voltage or current supplied to the MST antenna 897-1 according to the received signal. The change in direction of the voltage or current makes it possible for the direction of a magnetic signal (e.g., a magnetic field) transmitted via the MST antenna 897-1 to change accordingly. When the magnetic signal in the state of changing direction is detected by the external electronic device 702, it may cause the magnetic signal to cause an effect (e.g., waveform) similar to a magnetic field generated when a magnetic card corresponding to the received signal (e.g., card information) is swiped with a card reader of the electronic device 702. According to an embodiment, the payment-related information and the control signal received in the form of the magnetic signal by the electronic device 702 may be, for example, transmitted to the external server 708 (e.g., a payment server) via the network 799.

The NFC communication module 830 may obtain a signal including control information or payment-related information such as card information from the processor 720, and transmit the obtained signal to the external electronic device 702 via the NFC antenna 897-3. According to an embodiment, the NFC communication module 830 may receive such a signal transmitted from the external electronic device 702 via the NFC antenna 897-3.

The wireless charging module 850 may wirelessly transmit power to the external electronic device 702 (e.g., a mobile phone or a wearable device) via the wireless charging antenna 897-5, or wirelessly receive power from the external electronic device 702 (e.g., a wireless charging device). The wireless charging module 850 may support at least one of various wireless charging methods including, for example, a magnetic resonance scheme or a magnetic induction scheme.

According to an embodiment, some of the MST antenna 897-1, the NFC antenna 897-3, or the wireless charging antenna 897-5 may share at least a portion of a radiation part with each other. For example, the radiation part of the MST antenna 897-1 may be used as a radiation part of either the NFC antenna 897-3 or the wireless charging antenna 897-5, and vice versa. In this case, the antenna module 897 may include a switching circuit (not shown) configured to selectively connect (e.g., close) or disconnect (e.g., open) at least some of the antennas 897-1, 897-3, or 897-5, under the control of the wireless communication module 792 (e.g., the MST communication module 810 or the NFC communication module 830) or the power management module 788 (e.g., the wireless charging module 850). For example, in the case that the electronic device 701 uses the wireless charging function, the NFC communication module 830 or the wireless charging module 850 may control the switching circuit to temporarily disconnect at least a partial area of the radiation part shared by the NFC antenna 897-3 and the wireless charging antenna 897-5 from the NFC antenna 897-3 and then connect the same to the wireless charging antenna 897-5.

According to an embodiment, at least one function of the MST communication module 810, the NFC communication module 830, or the wireless charging module 850 may be controlled by an external processor (e.g., the processor 720). According to an embodiment, designated functions (e.g., payment-related function) of the MST communication module 810 or the NFC communication module 830 may be performed in a trusted execution environment (TEE). According to various embodiments, the TEE may form an execution environment in which at least some designated region of the memory 730 is allocated for use in performing a certain function that requires a relatively high level of security (e.g., a financial transaction or a personal information-related function). In such a case, the access to the designated region may be allowed in a limited manner, for example, depending upon a subject accessing the designated region or an application executed in the TEE.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

The various embodiments and terms used herein are not intended to limit the technical features described herein to specific embodiments and should be understood to include various modifications, equivalents, or substitutes of the embodiment. In connection with the description of the drawings, like reference numerals may be used for similar or related components. The singular form of a noun corresponding to an item may include one or more of the item, unless the relevant context clearly dictates otherwise. In this document, each of the phrases such as "A or B", "at least one of A and B", "at least one of A or B", "A, B or C", "at least one of A, B and C", and "at least one of A, B, or C" may include any one of the items enumerated together in a corresponding one of the phrases, or all possible combinations thereof. Terms such as "the first", "the second", or "first", or "second" may be used simply to distinguish a corresponding component from another corresponding component, and do not limit the corresponding components in view of other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

The term "module" used in various embodiments of the present document may include a unit implemented in hardware, software, or firmware and be used interchangeably with terms such as e.g., logic, logic block, part, component, or circuitry, for example. The module or unit may be a minimum unit or a part of the integrally configured component or the component that performs one or more functions. For example, according to an embodiment, the module or unit may be implemented in the form of an application-specific integrated circuit (ASIC).

Various embodiments as set forth herein may be implemented as software (e.g., the program 840) including one or more instructions that are stored in a storage medium (e.g., an internal memory 836 or an external memory 838) that is readable by a machine (e.g., the electronic device 801). For example, a processor (e.g., the processor 820) of the machine (e.g., the electronic device 801) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments of the disclosure, each component (e.g., a module or a program) of the above-described components may include a single entity or multiple entities, and some of the multiple entities may be separately disposed in different components. According to various embodiments of the disclosure, one or more of the above-described components may be omitted, or one or more other components may be added. Alternatively or additionally, a plurality of components (e.g., modules or programs) may be integrated into a single component. In such a case, according to various embodiments of the disclosure, the integrated component may still perform one or more functions of each of the plurality of components in the same or similar manner as they are performed by a corresponding one of the plurality of components before the integration. According to various embodiments of the disclosure, operations performed by the module, the program, or another component may be carried out sequentially, in parallel, repeatedly, or heuristically, or one or more of the operations may be executed in a different order or omitted, or one or more other operations may be added.

It will be appreciated that the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. An electronic device (100), comprising:
a display (150);
a housing (310) including a transparent front side plate (111) through which the display (150) can be viewed, a rear side plate (112) spaced apart from the front side plate and disposed to be parallel thereto, and a side surface member (113) connected to the front side plate and the rear side plate;
at least one camera;
at least one electronic component located inside the housing;
a conductive wall (312) formed between the at least one camera and the at least one electronic component;
a side key (320) located in at least one opening formed in a part of the side surface member; and
a side key flexible printed circuit board, FPCB, for detecting a depression of the side key, and to generate and transmit an electrical signal in response to a detection of the depression of the side key,
wherein a first portion of the side surface member adj acent to the side key is a first antenna,
wherein the side key FPCB includes a first connector connected to the first antenna to transmit a first radio frequency, RF, signal to the first antenna,
wherein the side key FPCB includes an extended part extending into an inside of the electronic device,
wherein the extended part is disposed between the camera and the conductive wall, and
wherein the conductive wall includes at least one hole (404) formed in a partial region of the conductive wall corresponding to the extended part.

2. The electronic device according to claim 1,
wherein a second portion of the side surface member adjacent to the side key is a second antenna, and
wherein the side key FPCB includes a second connector connected to the second antenna to transmit a second RF signal to the second antenna.

3. The electronic device according to claim 2, wherein a first slot is formed in an area corresponding to the first portion of the side surface member, and a second slot is formed in an area corresponding to the second portion of the side surface member, amongst the entire area of the bracket.

4. The electronic device according to claim 3, wherein the electronic device forms resonance through the first slot and the second slot.

5. The electronic device according to claim 3 or claim 4, wherein electromagnetic waves are radiated from the side surface member through regions corresponding to the first slot and the second slot.

6. The electronic device according to any of the preceding claims,
wherein the extended part of the side key FPCB includes at least one transmission line through which the first RF signal or the second RF signal is transferred, and
wherein a distance between the at least one hole (404) formed in the conductive wall and the at least one transmission line is shorter than a distance between the conductive wall and the transmission line.

7. The electronic device according to any of the preceding claims, wherein the electronic component includes a battery.

8. The electronic device according to any of the preceding claims,
wherein the side surface member is configured to extend to include a bracket supporting the display, and
wherein the conductive wall is formed extending from a portion of the bracket.

9. The electronic device according to any of the preceding claims,
wherein the at least one camera is configured to capture an image of a subject through a direction the rear side plate faces, and
wherein the at least one camera is disposed adjacent to the side key on an upper part of the electronic device.

10. The electronic device according to claim 1, wherein the side key FPCB comprises:
a base layer;
a first conductive layer (510) located in a first direction of the base layer;
a second conductive layer (530) located in a second direction opposite to the first direction of the base layer; and
a transmission line (504) disposed across the first conductive layer, the base layer, and the second conductive layer.

11. The electronic device according to claim 10, wherein the transmission line comprises:
a first transmission line (540, 546, or 548) disposed on the first conductive layer, and
a second transmission line (544) disposed on the second conductive layer,
wherein the first transmission line and the second transmission line are connected through a plurality of vias (542) passing through the base layer.

12. The electronic device according to claim 11, wherein the second transmission line is disposed in at least one hole area (506) corresponding to the at least one hole (404).

13. The electronic device according to claim 12, wherein the first transmission line is disposed in an area other than the at least one hole area.

14. The electronic device according to claim 12, wherein the plurality of vias are disposed in or at a boundary area of the hole area.

15. The electronic device according to claim 11, wherein the transmission line is grounded through the first conductive layer.

## Patentansprüche

1. Elektronische Vorrichtung (100), umfassend:
eine Anzeige (150);
ein Gehäuse (310), das eine transparente Frontseitenplatte (111) enthält, durch die die Anzeige (150) sichtbar ist, eine Rückseitenplatte (112), die mit Abstand zur Frontseitenplatte und parallel dazu angeordnet ist, und ein Seitenflächenelement (113), das mit der Frontseitenplatte und der Rückseitenplatte verbunden ist;
mindestens eine Kamera;
mindestens eine elektronische Komponente, die sich im Inneren des Gehäuses befindet;
eine leitfähige Wand (312), die zwischen der mindestens einen Kamera und der mindestens einen elektronischen Komponente ausgebildet ist;
ein Seitenschlüssel (320), der sich in mindestens einer Öffnung befindet, die in einem Teil des Seitenflächenelements ausgebildet ist; und
eine flexible Seitenschlüsselleiterplatte, FPCB, zum Erfassen eines Tastendrucks des Seitenschlüssels und zum Erzeugen und Übertragen eines elektrischen Signals als Reaktion auf die Erfassung des Tastendrucks des Seitenschlüssels,
wobei ein erster Abschnitt des Seitenflächenelements, der an den Seitenschlüssel angrenzt, eine erste Antenne ist,
wobei die Seitenschlüssel-FPCB einen ersten Anschluss enthält, der mit der ersten Antenne verbunden ist, um ein erstes Hochfrequenzsignal (RF) an die erste Antenne zu übertragen,
wobei die Seitenschlüssel-FPCB einen verlängerten Teil enthält, der sich in ein Inneres der elektronischen Vorrichtung erstreckt,
wobei der verlängerte Teil zwischen der Kamera und der leitfähigen Wand angeordnet ist, und
wobei die leitfähige Wand mindestens ein Loch (404) enthält, das in einem Teilbereich der leitfähigen Wand ausgebildet ist, der dem verlängerten Teil entspricht.

2. Elektronische Vorrichtung nach Anspruch 1,
wobei ein zweiter Abschnitt des Seitenflächenelements, der an den Seitenschlüssel angrenzt, eine zweite Antenne ist, und
wobei die Seitenschlüssel-FPCB einen zweiten Anschluss enthält, der mit der zweiten Antenne verbunden ist, um ein zweites Hochfrequenzsignal (RF) an die zweite Antenne zu übertragen.

3. Elektronische Vorrichtung nach Anspruch 2, wobei ein erster Schlitz in einer Fläche ausgebildet ist, die dem ersten Abschnitt des Seitenflächenelements entspricht, und ein zweiter Schlitz in einer Fläche ausgebildet ist, die dem zweiten Abschnitt des Seitenflächenelements entspricht, innerhalb der gesamten Fläche der Halterung.

4. Elektronische Vorrichtung nach Anspruch 3, wobei elektronische Vorrichtung durch den ersten Schlitz und den zweiten Schlitz Resonanz ausbildet.

5. Elektronische Vorrichtung nach Anspruch 3 oder 4, wobei elektromagnetische Wellen von dem seitlichen Seitenflächenelement durch Bereiche abgestrahlt werden, die den ersten und zweiten Schlitz entsprechen.

6. Elektronische Vorrichtung nach einem der vorhergehenden Ansprüche,
wobei der erweiterte Teil der Seitenschlüssel-FPCB mindestens eine Übertragungsleitung enthält, durch welche das erste Hochfrequenzsignal (RF) oder das zweite Hochfrequenzsignal (RF) übertragen wird, und
wobei ein Abstand zwischen dem mindestens einen Loch (404), das in der leitfähigen Wand ausgebildet ist, und der mindestens einen Übertragungsleitung kürzer ist als ein Abstand zwischen der leitfähigen Wand und der Übertragungsleitung.

7. Elektronische Vorrichtung nach einem der vorhergehenden Ansprüche, wobei elektronische Komponente eine Batterie enthält.

8. Elektronische Vorrichtung nach einem der vorhergehenden Ansprüche,
wobei das Seitenflächenelement so konfiguriert ist, dass es sich erweitert um eine Halterung zu enthalten, die die Anzeige trägt, und
wobei die leitfähige Wand ausgebildet ist, dass sie sich aus einem Abschnitt der Halterung erstreckt.

9. Elektronische Vorrichtung nach einem der vorhergehenden Ansprüche,
wobei mindestens eine Kamera so konfiguriert ist, dass sie ein Bild eines Subjekts in der Richtung aufnimmt, in welche die Rückseitenplatte zeigt, und
wobei die mindestens eine Kamera an einem oberen Teil der elektronischen Vorrichtung angrenzend an den Seitenschlüssel angeordnet ist.

10. Elektronische Vorrichtung nach Anspruch 1, wobei die Seitenschlüssel-FPCB umfasst:
eine Basis-Schicht;
eine erste leitfähige Schicht (510), die sich in einer ersten Richtung der Basisschicht befindet;
eine zweite leitfähige Schicht (530), die sich in einer zweiten, der ersten entgegengesetzten Richtung der Basisschicht befindet; und
eine Übertragungsleitung (504), die über die erste leitfähige Schicht, die Basisschicht und die zweite leitfähige Schicht angeordnet ist.

11. Elektronische Vorrichtung nach Anspruch 10, wobei die Übertragungsleitung umfasst:
eine erste Übertragungsleitung (540, 546 oder 548), die auf der ersten leitfähigen Schicht angeordnet ist, und
eine zweite Übertragungsleitung (544), die auf der zweiten leitfähigen Schicht angeordnet ist,
wobei die erste Übertragungsleitung und die zweite Übertragungsleitung durch mehrere Verbindungskontakte (542), die durch die Basisschicht verlaufen, verbunden sind.

12. Elektronische Vorrichtung nach Anspruch 11, wobei die zweite Übertragungsleitung in mindestens einer Lochfläche (506) angeordnet ist, die dem mindestens einen Loch (404) entspricht.

13. Elektronische Vorrichtung nach Anspruch 12, wobei die erste Übertragungsleitung in einer Fläche angeordnet ist, die sich von der mindestens einen Lochfläche unterscheidet.

14. Elektronische Vorrichtung nach Anspruch 12, wobei die mehreren Verbindungskontakte in oder an einer Randfläche der Lochfläche angeordnet sind.

15. Elektronische Vorrichtung nach Anspruch 11, wobei die Übertragungsleitung durch die erste leitfähige Schicht hindurch geerdet ist.

## Revendications

1. Dispositif électronique (100), comprenant :
un dispositif d'affichage (150) ;
un boîtier (310) comprenant une plaque latérale avant transparente (111) à travers laquelle le dispositif d'affichage (150) peut être vu, une plaque latérale arrière (112) espacée de la plaque latérale avant et disposée pour être parallèle à celle-ci, et un élément de surface latérale (113) relié à la plaque latérale avant et à la plaque latérale arrière ;
au moins une caméra ;
au moins un composant électronique situé à l'intérieur du boîtier ;
une paroi conductrice (312) formée entre l'au moins une caméra et l'au moins un composant électronique ;
une touche latérale (320) située dans au moins une ouverture formée dans une pièce de l'élément de surface latérale ; et
une carte de circuit imprimé souple, FPCB, à touche latérale pour détecter un enfoncement de la touche latérale, et pour générer et transmettre un signal électrique en réponse à une détection de l'enfoncement de la touche latérale,
dans lequel une première partie de l'élément de surface latérale adjacente à la touche latérale est une première antenne,
dans lequel la FPCB à touche latérale comprend un premier élément de liaison relié à la première antenne pour transmettre un premier signal radiofréquence, RF, à la première antenne,
dans lequel la FPCB à touche latérale comprend une pièce étendue s'étendant à l'intérieur du dispositif électronique,
dans lequel la pièce étendue est disposée entre la caméra et la paroi conductrice, et
dans lequel la paroi conductrice comprend au moins un trou (404) formé dans une région partielle de la paroi conductrice correspondant à la pièce étendue.

2. Dispositif électronique selon la revendication 1,
dans lequel une seconde partie de l'élément de surface latérale adjacente à la touche latérale est une seconde antenne, et
dans lequel la FPCB à touche latérale comprend un second élément de liaison relié à la seconde antenne pour transmettre un second signal RF à la seconde antenne.

3. Dispositif électronique selon la revendication 2, dans lequel une première fente est formée dans une zone correspondant à la première partie de l'élément de surface latérale, et une seconde fente est formée dans une zone correspondant à la seconde partie de l'élément de surface latérale, parmi la zone entière du support.

4. Dispositif électronique selon la revendication 3, dans lequel le dispositif électronique forme une résonance à travers la première fente et la seconde fente.

5. Dispositif électronique selon la revendication 3 ou la revendication 4, dans lequel des ondes électromagnétiques sont émises à partir de l'élément de surface latérale à travers des régions correspondant à la première fente et à la seconde fente.

6. Dispositif électronique selon l'une quelconque des revendications précédentes,
dans lequel la pièce étendue de la FPCB à touche latérale comprend au moins une ligne de transmission à travers laquelle le premier signal RF ou le second signal RF est transféré, et
dans lequel une distance entre l'au moins un trou (404) formé dans la paroi conductrice et l'au moins une ligne de transmission est plus courte qu'une distance entre la paroi conductrice et la ligne de transmission.

7. Dispositif électronique selon l'une quelconque des revendications précédentes, dans lequel le composant électronique comprend une batterie.

8. Dispositif électronique selon l'une quelconque des revendications précédentes,
dans lequel l'élément de surface latérale est conçu pour s'étendre afin de comprendre un support supportant le dispositif d'affichage, et
dans lequel la paroi conductrice est formée en s'étendant depuis une partie du support.

9. Dispositif électronique selon l'une quelconque des revendications précédentes,
dans lequel l'au moins une caméra est conçue pour capturer une image d'un sujet à travers une direction des faces de la plaque latérale arrière, et
dans lequel l'au moins une caméra est disposée adjacente à la touche latérale sur une pièce supérieure du dispositif électronique.

10. Dispositif électronique selon la revendication 1, dans lequel la FPCB à touche latérale comprend :
une couche de base ;
une première couche conductrice (510) située dans une première direction de la couche de base ;
une seconde couche conductrice (530) située dans une seconde direction opposée à la première direction de la couche de base ; et
une ligne de transmission (504) disposée à travers la première couche conductrice, la couche de base et la seconde couche conductrice.

11. Dispositif électronique selon la revendication 10, dans lequel la ligne de transmission comprend :
une première ligne de transmission (540, 546 ou 548) disposée sur la première couche conductrice, et
une seconde ligne de transmission (544) disposée sur la seconde couche conductrice,
dans lequel la première ligne de transmission et la seconde ligne de transmission sont reliées à travers une pluralité de trous d'interconnexion (542) passant à travers la couche de base.

12. Dispositif électronique selon la revendication 11, dans lequel la seconde ligne de transmission est disposée dans au moins une zone de trou (506) correspondant à l'au moins un trou (404).

13. Dispositif électronique selon la revendication 12, dans lequel la première ligne de transmission est disposée dans une zone autre que l'au moins une zone de trou.

14. Dispositif électronique selon la revendication 12, dans lequel la pluralité de trous d'interconnexion sont disposés dans ou au niveau d'une zone limite de la zone de trou.

15. Dispositif électronique selon la revendication 11, dans lequel la ligne de transmission est mise à la terre à travers la première couche conductrice.
